Europäisches Patentamt

(19) European Patent Office

Office européen des brevets

(11) Publication number: **0 129 993**
**A1**

(12) # EUROPEAN PATENT APPLICATION

(21) Application number: **84303709.4**

(22) Date of filing: **01.06.84**

(51) Int. Cl.⁴: **G 01 R 1/073**
**G 01 R 19/165, G 01 R 31/02**

(30) Priority: **01.06.83 US 499984**

(43) Date of publication of application:
**02.01.85 Bulletin 85/1**

(84) Designated Contracting States:
**DE FR GB NL SE**

(71) Applicant: **Festa, Joseph F.**
**4561 Calle De Tosca**
**San Jose CA 95118(US)**

(72) Inventor: **Festa, Joseph F.**
**4561 Calle De Tosca**
**San Jose CA 95118(US)**

(74) Representative: **Wright, Peter David John et al,**
**R.G.C. Jenkins & Co. 12-15, Fetter Lane**
**London EC4A 1PL(GB)**

(54) **Circuit board tester.**

(57) A device for its use is disclosed for electrically inspecting circuit boards having edge connector fingers for electrical shorts. A unique housing (10) and electrical contact arm structure (60, 88) are provided so that the unit may be held in one hand and applied directly to the circuit board by sliding it along the length of the connector fingers in a single motion in one direction. The contacts are easily adjusted to accommodate any finger spacing up to 0.25 inch, as well as any finger material such as copper, nickel, silver or gold. The tester is battery powered (100) and fully portable and uses only low voltage and low level direct current, so that it may safely be used on circuit boards with or without electronic components. A short is signalled by audio (120), visual (130) and tactile signals. A separate set of electrical jacks are also provided so the tester can also be used with external leads as a conventional continuity tester.

FIG. 2

Croydon Printing Company Ltd.

CIRCUIT BOARD TESTER

Background of the Invention

Printed circuit boards are used in many electronic instruments for connecting and mounting components. Generally, these circuit boards consist of a flat, insulated board covered with a larger number of individual conductive runs. The runs are usually copper and often are covered with a thin layer of nickel, silver or gold to prevent corrosion of the underlying copper. Connection of the circuits on an individual circuit board to the other circuits within an instrument is often by means of regularly spaced contacts arranged closely together along an edge of the circuit board in the form of "fingers" to form an edge connector. In operation the edge connector of each circuit board is plugged into a mating connector having spaced electrical contacts which align with the fingers of the edge connector.

Because of the large number of individual conductive traces, circuit boards are usually inspected both before and after the mounting of components to insure that the traces which are intended to be electrically isolated are in fact not shorted together. This is usually done by both an electrical and a visual inspection. The initial electrical inspection is straight forward, but both tedious and time consuming. The probes of a continuity tester are sequential and brought into contact with adjacent fingers of the circuit board one pair at a time, and any electrical shorts cause the tester to generate a visual or audible signal. Since each probe is independent of the other with the operator generally holding one in each hand, it is easy to skip one or more fingers while testing a board. Further since that method requires a great deal of concentration during the testing process, the inspector quickly finds his eyes going crossed after continually viewing the closely spaced fingers on the circuit boards his is checking. Using this classical method, a trained inspector will require approximately 40 seconds to test the connector fingers on both sides of a typical 4-inch edge connector.

What is needed is a continuity tester in which the probe spacing can be preset to the spacing between the circuit board spacing and then drawn along the edge of the board to his eyes on the board fingers when a short is indicated.

## Summary of the Invention

The present invention provides a new and improved electronic testing device which permits the electrical testing of circuit boards in less time and with less tedium than the conventional devices and methods. A novel handheld unit is applied to the fingers of the circuit board and traversed along the entire length of the edge connector in a single motion, either left to right or right to left. If a low electrical impedance is encountered, audio, visual, and tactile indications are produced to rapidly and accurately signal the inspector of its existance.

The testing unit is totally self-contained and portable, thus eliminating the need for cumbersome test leads for manually testing of connector fingers. The unit is also provided with test lead jacks so that conventional circuit board testing can be carried out when needed or desired. The test signal is both low voltage and low current therefore eliminating potential damage to components when testing circuit boards already loaded with components.

Using the present invention, an inspector can test the connector fingers on both sides of a typical 4-inch edge connector in approximately four seconds--an improvement by a factor of 10 over prior art methods.

## Description of the Drawings

Figure 1 is a partially cut-away view of a circuit board tester according to a first embodiment of the present invention in conjunction with a printed circuit board under test.

Figure 2 is a vertical cross-sectional view of the circuit board tester as shown in Figure 1.

Figure 3 is a bottom perspective view of the circuit board tester as shown in Figure 1.

Figure 4 is a vertical cross-sectional view of a second embodiment of the present invention.

Figure 5 is a perspective view of the circuit board tester of Figure 1.

Detailed Description of the Invention

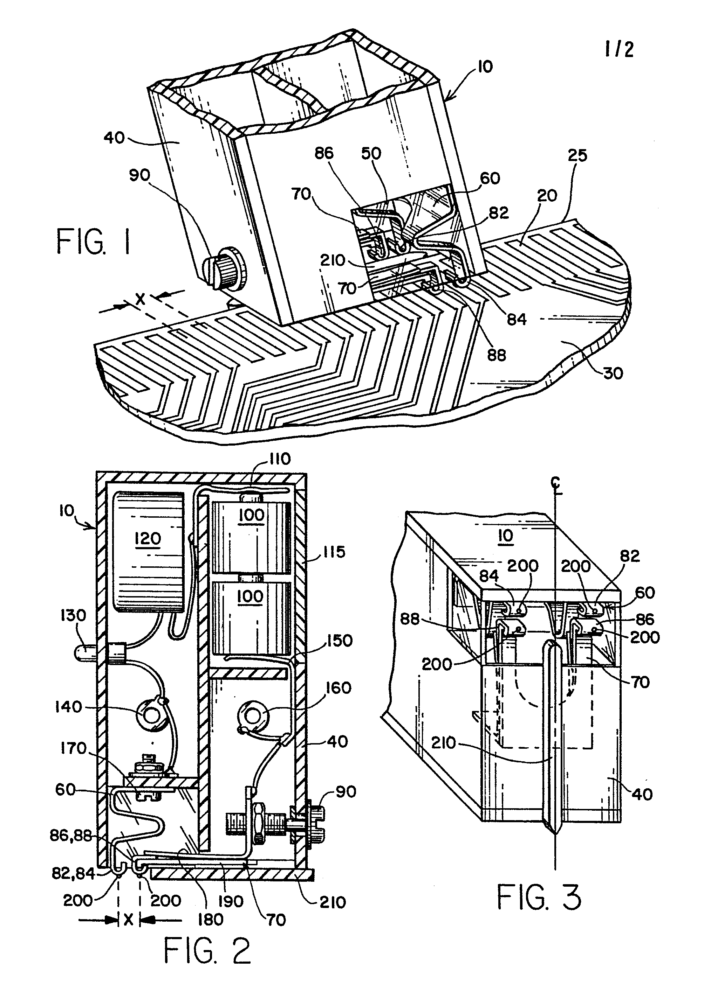

Figure 1 shows a partially cut-away view of the circuit board tester 10 in its application position relative to the edge finger connector contacts 20 of a printed circuit board 30. The tester 10 is housed in a housing 40 that is composed of an insulating material, such as a plastic, which is both lightweight and durable. Housing 40 includes transparent plastic windows 50 on both sides of the housing 40 which permit a clear and unobstructed view of a stationary bifurcated contact arm 60 and an adjustable bifurcated contact arm 70 as they come in contact with finger connector contacts 20. Each of contact arms 60 and 70 includes a pair of contacts 82 and 84, and 86 and 88, respectively, so that the tester 10 can be used equally well with the left or right hand. The actual measurement between adjacent fingers 20 is made using either contact 82 in conjunction with contact 86 or contact 84 in conjunction with contact 88. The adjustable contact arm 70 can be moved relative to the stationary contact arm 60 in a plane parallel to the bottom of housing 40 by means of a screw 90 (see Figure 2) formed from an insulating material such as nylon. The adjustability of arm 70 relative to stationary arm 60 increases its versatility and permits the use of the tester 10 with circuit boards 30 having fingers 20 having different spacings "X" therebetween. This adjustability is important since the spacing "X" between contacts 20 can vary from connector to connector (e.g. 0.100, 0.125, or 0.186 inch).

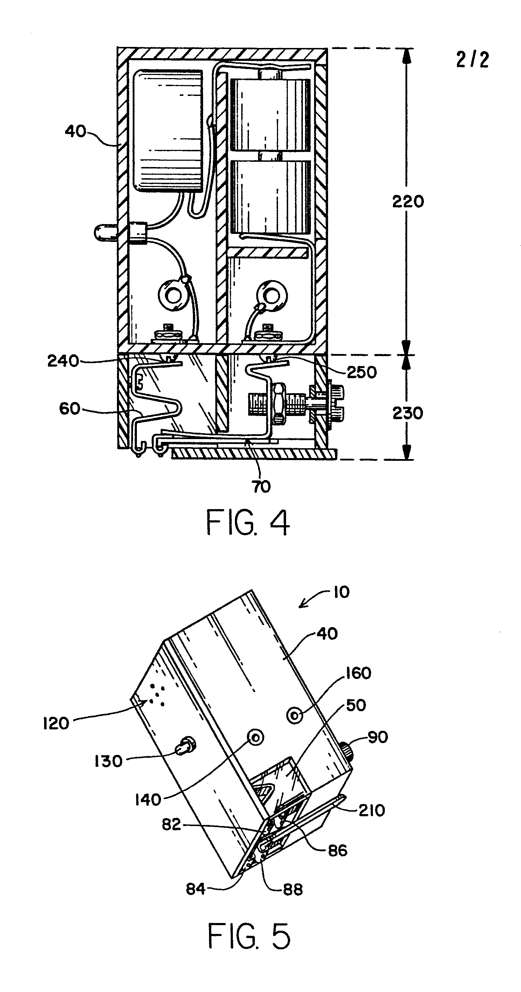

Figure 2 shows a vertical cross-sectional view of the tester 10 and Figure 5 shows a perspective view of the fully assembled device. Power is provided by a pair of 1.4 volt batteries 100 connected in series and installed through removable cover 115 between battery spring contacts 110 and 150. Buzzer 120 is shown connected in series with lamp 130 between battery contact 110 and stationary contact arm 60. Stationary contact arm 60 is also connected to a positive jack 140. Battery contact 150 is shown connected to the adjustable contact arm 70 and to a negative jack 160. Adjustable contact arm 70 is adjustably mounted on screw 90 which is rotatably mounted to the side wall of housing 40. The spacing "X" between adjustable contact arm 70 and stationary contact arm 60 is adjustable by turning screw 90.

Jacks 140 and 160 provide a means for attaching a pair of conventional meter leads (not shown) to the continuity tester circuit with housing 40 to permit the testing of circuit boards 30 in the traditional, fully manual mode. Jacks 140 and 160 can also serve to couple the tester 10 to other electronic devices where a low impedance alarm is desired.

The stationary bifurcated contact arm 60 may be formed from a single piece of spring type 25% hard, .010 inch thick copper, or a similar material for both strength and resilience. Stationary contact arm 60 is mounted within housing 40 by a mounting screw 170 with its contacts 82 and 84 extending beyond the bottom end of housing 40. The adjustable bifurcated contact arm 70 is constructed of four parts: a bifurcated frame 190 made of a dielectric material such as nylon; an electrically conductive spring 180; and contacts 86 and 88, also made of spring type metal. Frame 190 and spring 180 are each adjustably mounted on screw 90. Contacts 86 and 88 clip over each tine of the bifurcated frame 190 and are held in place by, and come into electrical contact with remainder of the circuit through, conductive spring 180. As mounted, contacts 86 and 88 also extend beyond the bottom end of housing 40. In addition, each contact 82, 84, 86 and 88 has a small dimple-like protrusion 200 formed on the surface which is placed in contact with the fingers 20 to insure electrical contact with the fingers 20.

Generally, it is desirable that the surface of the contacts 82, 84, 86, and 88 or at least the protrusions 200 be plated with or constructed from the same material as is used in plating the fingers 20 (e.g. gold, nickel, or silver) to minimize damage to the circuit board during testing. In addition, since the small protrusions 200 may become worn after extended use, it is a simple matter to change contact arm 60 and contacts 86, and 88. Contact arm 60 may be changed by loosing mounting screw 170 and installing a new stationary contact arm 60 thereunder. Contacts 86 and 88 may be changed by pushing the ends of spring 180 away from the tines of frame 190.

Figure 3 shows a bottom perspective view of tester 10 showing the contact arms 60 and 70 along with the small protrusions 200 in greater detail. Also shown is an alignment guide 210 which is permanently mounted on the housing 40 centered along the center line C/L between the contact pairs 82, 86, and 84, 88. In use, alignment guide 210 is maintained in contact with the edge of circuit board 30 (see Figure 1) to insure the proper alignment of the tester 10 with the fingers 20 along the edge 25 of circuit board 30. In addition, since alignment guide 210 is centered on the bottom of housing 40, the tester 10 can be used along the edge 25 in either direction.

The tester 10 is used by first adjusting the desired spacing "X" between protrusions 200 of contacts 82, 84, 86 and 88 with screw 90 to match the spacing "X" to that of the fingers 20 on the circuit board to be tested. The operator then aligns the alignment guide 210 with the edge 25 of the circuit board 30 and causes the contacts to traverse the fingers 20. If an electrical short between adjacent fingers 20 is encountered, the buzzer 120 will sound and the light 130 will light producing both an audio and visual indication of the short. In addition, the buzzer 120 will cause the housing 40 to resonate producing a tactile indication of a short when the tester 10 is being handheld.

Figure 4 shows a second embodiment of the present invention in which the housing 40 is composed of a control unit 220 and a contact unit 230 wherein the later slidably engages the former. The contact unit 230 houses the contact arms 60 and 70 which are in turn connected electrically to the control unit 220 by spring contact points 240 and 250. This second embodiment facilitates the rapid exchange of contact arms 60 and 70. Thus a plurality of contact units 230 can be set up for different finger spacings "X" or for different finger materials (e.g. copper, silver, gold or nickel) to be used with a single control unit 220. Additionally, the inspector may replaced worn contacts quickly with just as much ease.

0129993

CLAIMS

1. An apparatus for detecting low impedance paths in electronic circuits, said apparatus comprising:
first and second contact means for making electrical contact with selected portions of said electronic circuit;
adjustment means for selectively positioning said first and second contact means relative to each other; and
signal means electrically coupled between said first and second contact means for indicating the presence of an external low electrical impedance path between the first and second contact means.

2. An apparatus as in claim 1 further comprising alignment means for orienting said first and second contact means with the portions of said electronic circuit around its outer periphery.

3. An appartus for detecting low impedance paths in electronic circuits, said apparatus comprising:
first and second contact means for making electrical contact with selected portions of said electronic circuit;
alignment means for orienting said first and second contact means with the portions of said electronic circuit around its outer periphery; and
signal means electrically coupled between said first and second contact means for indicating the presence of an external low electrical impedance path between the first and second contact means.

4. An apparatus as in claim 3 further comprising adjustment means for selectively positioning said first and second contact means relative to each other.

2

0129993

5. An apparatus for detecting low impedance paths between traces of a printed circuit board having uniformly spaced connector fingers printed thereon along at least one edge therof, said apparatus comprising:

first contact means for making an electrical connection with a first connector finger;

second contact means for making an electrical connection with a second connector finger;

alignment means mechanically coupled to said first and second means for orienting the first and second contact means relative to the connector fingers along the edge of the circuit board; and

signal means electrically coupled between said first and second contact means for indicating the presence of an external low electrical impedance path between the first and second contact means.

6. An apparatus as in claim 5 further comprising adjustment means for selectively positioning said first and second contact means relative to each other.

7. An apparatus as in claim 5 wherein said first and second contact means each includes a bifurcated contact having a first and second prong, each arranged synmmetrically about said alignment means.

8. An apparatus as in claim 6 wherein said first and second contact means each includes a spring loaded electrical contact.

9. An apparatus as in claim 8 wherein said spring loaded electrical contact has a dimple-like protrusion for positively contacting said connector fingers.

10. An apparatus as in claim 7 wherein the first and second prongs of each of said first and second contact means comprises an electrically conductive material.

11. An apparatus as in claim 10 wherein the first and second prongs of each of bifurcated contacts have at least a surface coating of a metal compatable with the surface metalization of the connector fingers of the printed circuit board.

12. An apparatus as in claim 8 wherein said electrical contacts are removable and replaceable.

13. An apparatus as in claim 5 further comprising first and second electrical jacks, electrically coupled to said first and second contact means respectively.

14. An apparatus as in claim 5 wherein said signal means comprises:
a battery; and
a buzzer connected to the battery and one of said first and second contact means.

15. A testing apparatus as in claim 5 wherein said signal means comprises:
a battery; and
a lamp connected to the battery and one of said first and second contact means.

16. An apparatus as in claim 5 wherein said signal means comprises:
a battery;
a buzzer; and
a lamp;
both the buzzer and the lamp connected to the battery and one of said first and second contact means.

4

0129993

17. An apparatus as in claim 5 further comprising interconnect means interposed between the first and second contact means and the signal means respectively for mechanically and electrically removably connecting the first and second contact means to the signal means.

FIG. 1

FIG. 2

FIG. 3

2/2

40

220

240

250

60

230

70

**FIG. 4**

10

40

160

50

90

120

130

140

82

210

86

84

88

**FIG. 5**

# EUROPEAN SEARCH REPORT

## DOCUMENTS CONSIDERED TO BE RELEVANT

| Category | Citation of document with indication, where appropriate, of relevant passages | Relevant to claim | CLASSIFICATION OF THE APPLICATION (Int. Cl. ³) |
|---|---|---|---|
| X | DE-A-2 912 826 (H. LAASS)<br>* Claims 1, 6; page 8, lines 12-27; figure 4 * | 1,3-5 | G 01 R 1/078<br>G 01 R 19/165<br>G 01 R 31/02 |
| A | | 14,15 | |
| | --- | | |
| X | US-A-3 537 000 (M.D. EASI)<br>* Column 3, line 66 - column 4, line 71; figure 1 * | 1,3-5 | |
| A | | 8,10 | |
| | --- | | |
| A | ELEKTOR, vol. 7, no. 7/8, July/August 1981, Canterbury, GB; "Continuity tester", pages 800-801<br>* Pages 800-801 * | 14,15 | |
| | --- | | TECHNICAL FIELDS SEARCHED (Int. Cl. ³) |
| A | GB-A-1 283 012 (HEWLETT-PACKARD)<br>* Page 3, lines 68-87; figure 3 * | 1 | G 01 R 1/067<br>G 01 R 1/078<br>G 01 R 19/165<br>G 01 R 31/02 |
| | --- | | |
| A | US-A-4 176 315 (E.D. SUNNARBORG)<br>* Figures 1, 7 * | 1,14, 15 | |
| | ----- | | |

The present search report has been drawn up for all claims

| Place of search | Date of completion of the search | Examiner |
|---|---|---|
| BERLIN | 23-08-1984 | LEMMERICH J |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO Form 1503 03 82